Europäisches Patentamt

European Patent Office

Office européen des brevets

(19)

(11) Veröffentlichungsnummer : **0 460 260 B1**

(12)

# EUROPÄISCHE PATENTSCHRIFT

(45) Veröffentlichungstag der Patentschrift :
**21.12.94 Patentblatt 94/51**

(51) Int. Cl.$^5$ : **H04L 7/033, H03L 7/089**

(21) Anmeldenummer : **90110723.5**

(22) Anmeldetag : **06.06.90**

(54) **Schaltungsanordnung zur Nachlaufsynchronisation.**

(43) Veröffentlichungstag der Anmeldung :
**11.12.91 Patentblatt 91/50**

(45) Bekanntmachung des Hinweises auf die
Patenterteilung :
**21.12.94 Patentblatt 94/51**

(84) Benannte Vertragsstaaten :
**DE FR GB IT NL**

(56) Entgegenhaltungen :
**DE-A- 3 626 467**
**DE-C- 3 431 419**

(56) Entgegenhaltungen :
**IEEE JOURNAL OF SOLID-STATE CIRCUITS,
Band 24, nr. 2, April 1989, Seiten 325-330; S.Y.
SUN et al.: "An analog PLL-based clock and
data recovery circuit with high input jitter tolerance"**
**PATENT ABSTRACTS OF JAPAN, Band 4, Nr.
109 (E-20)[591], 6. August 1980; & JP-A-55 067
239 (SHINDENGEN KOGYO) 21-05-1980**

(73) Patentinhaber : **SIEMENS
AKTIENGESELLSCHAFT
Wittelsbacherplatz 2
D-80333 München (DE)**

(72) Erfinder : **Smolka, Georg, Dr.-Ing.
Luftiger Hof 19
D-8150 Holzkirchen (DE)**
Erfinder : **Werker, Heinz, Dipl.-Ing.
Hollernerstrasse 13
D-8057 Eching (DE)**
Erfinder : **Unterpointner, Franz
Moos 10
D-8099 Bahensham (DE)**

EP 0 460 260 B1

**Beschreibung**

Die Erfindung betrifft eine Schaltungsanordnung zur Nachlaufsynchronisation gemäß dem Oberbegriff des Patentanspruchs 1.

Bei der digitalen Nachrichtenübertragung ist es notwendig, im Empfänger den Takt aus dem Sendesignal Zurückzugewinnen. Dazu werden üblicherweise Schaltungsanordnungen zur Nachlaufsynchronisation, auch Phase-Locked-Loop-Schaltungen (PLL) genannt, verwendet. Derartige Schaltungsanordnungen weisen einen steuerbaren Oszillator auf, dessen Ausgangssignal in einem Phasendetektor mit einer Eingangsfrequenz verglichen wird. Das Ausgangssignal des Phasendetektors wiederum stellt über eine Regelstrecke, die beispielsweise aus einer Ladungspumpe und einem nachgeschaltetem Schleifenfilter besteht, die Frequenz des steuerbaren Oszillators ein.

Die Rückgewinnung des Taktes aus dem digitalen Datenstrom soll möglichst unempfindlich gegenüber dem Jitter der in beliebigen Bitmustern ankommenden Daten sein. Die geschlossene Schleife des PLL-Regelkreises benötigt daher einerseits eine geringe Bandbreite, um auf den beliebigen Datenstrom aufzusynchronisieren, und andererseits eine große Bandbreite, damit der rückgewonnene Takt den verjitterten Daten zur sicheren Datenabtastung gut folgen kann. Um diesen gegensätzlichen Forderungen gerecht zu werden, wurde bisher bei analogen PLL-Schaltungen ein Kompromiß bezüglich der Bandbreite der Regelschleife eingegangen. Dabei können jedoch abhängig vom Bitmuster der Daten andere Frequenzen entstehen, die nicht der tatsächlichen Taktfrequenz des Datenstroms entsprechen. Diese abweichenden Frequenzen treten insbesondere bei periodischen Datenfolgen auf und können durchaus innerhalb des Frequenzbereichs des gesteuerten Oszillators liegen. Es besteht also die Gefahr, daß der PLL-Regelkreis bei einer falschen Frequenz einrastet und somit eine falsche Taktfrequenz gewinnt.

Um diese Problematik zu umgehen, wurde, wie bei S. Y. Sun, An Analog PLL-Based Clock and Data Recovery Circuit with High Input Jitter Tolerance, IEEE, Journal of Solid-State Circuits, Vol. 24, No. 2, April 1989, S. 325-330 beschrieben, ein zusätzlicher Frequenzkomparator eingeführt, der den wiedergewonnenen Takt mit einem präzisen Referenztakt vergleicht. Beim Erkennen eines Fehlers wird der PLL-Regelkreis zur Synchronisation auf den Referenztakt geschaltet und anschließend wieder auf den Datenstrom. Damit ist jedoch ein beträchtlicher schaltungstechnischer Aufwand verbunden, da zum einen ein komplexer Frequenzvergleich ohne gleichzeitigen Phasenvergleich durchgeführt und zum anderen ein präziser Referenztakt zur Verfügung gestellt werden muß.

Aus der DE 36 26 467 ist eine Schaltungsanordnung für einen digitalen Phasendetektor bekannt, die bei Ausbleiben eines zu empfangenden Taktsignals keine Regelung eines spannungsgesteuerten Oszillators bewirkt. Ebenso ist aus der DE 34 31 419 eine Schaltungsanordnung bekannt, die bei einem lückenhaften Empfangssignal eine Verzögerung des Taktgebers verhindert.

Aufgabe der Erfindung ist es daher, eine Schaltungsanordnung zur Nachlaufsynchronisation anzugeben, die mit geringerem schaltungstechnischen Aufwand und besonders hoher Schaltgenauigkeit ein sicheres Einrasten auf der tatsächlichen Taktfrequenz des Datenstroms gewährleistet.

Die Aufgabe wird bei einer gattungsgemäßen Schaltungsanordnung zur Nachlaufsynchronisation durch die kennzeich nenden Merkmale des Patentanspruchs 1 gelöst. Ausgestaltungen und Weiterbildungen des Erfindungsgedankens sind in Unteransprüchen gekennzeichnet.

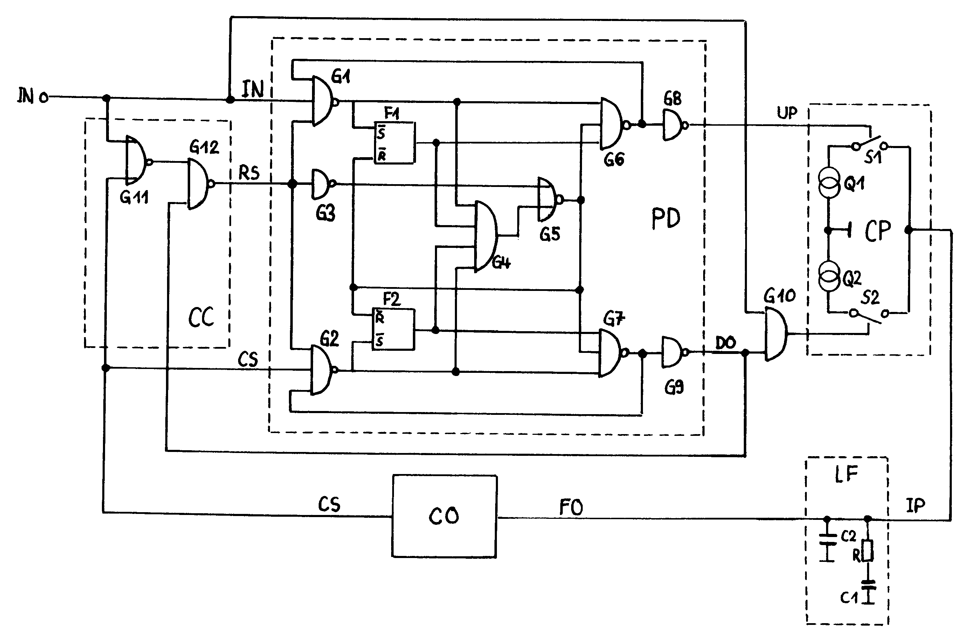

Die Erfindung wird nachfolgend anhand des in der einzigen Figur der Zeichnung dargestellten Ausführungsbeispiels näher erläutert.

Das gezeigte Ausführungsbeispiel weist einen Phasendetektor PD, an den ein Eingangssignal IN sowie ein Vergleichssignal CS angelegt sind und der zwei Ausgangssignale UP udn DO abgibt, eine Ladungspumpe CP, die beim Auftreten eines entsprechenden Ausgangssignals UP oder DO dese Phasendetektors PD einen Strom IP abgibt, ein Schleifenfilter, LF, dem der Strom IP zugeführt wird und daß ein Steuersignal FO abgibt, sowie einen Oszillator CO, auf. Der Oszillator CO gibt das Vergleichssignal CS ab, dessen Frequenz von dem Steuersignal FO des Schleifenfilters LF abhängt. Der Strom IP der Ladungspumpe CP wirkt beim Auftreten des Ausgangssignal DO als Ladestrom und beim Auftreten des Signals UP als Entladestrom.

Der Phasendetektor PD besteht erfindungsgemäß aus einem NAND-Gatter G1, an dessen Eingänge das Eingangssignal IN, ein Rücksetzsignal RS und ein erstes Rückkopplungssignal angelegt sind, und aus einem NAND-Gatter G2, an dessen Eingänge das Vergleichssignal CS, das Rücksetzsignal RS und ein zweites Rückkopplungssignal angelegt sind. Darüber hinaus besteht der Phasendetektor PD aus einem ersten Flip-Flop F1, dessen invertierender Setzeingang $\overline{S}$ mit dem Ausgang des NAND-Gatters G1 verbunden ist, und aus einem Flip-Flop F2, dessen invertierender Setzeingänge $\overline{S}$ mit dem Ausgang des NAND-Gatters G2 verbunden ist. Die Ausgänge der beiden Flip-Flops F1 und F2 sind ebenso wie die Ausgänge der beiden NAND-Gatter G1 und G2 an die Eingänge eines AND-Gatters G4 geführt. Der Ausgang eines NOR-Gatters G5, dessen Eingänge mit den Ausgängen eines mit den Rücksetzsignal RS beaufschlagten Inverters G3 sowie eines AND-Gatters G4 verschaltet sind, ist mit den invertierenden

Rücksetzeingängen $\overline{R}$ der Flip-Flops F1 und F2 gekoppelt.

Der Ausgang eines NAND-Gatters G6, dessen Eingänge an die Ausgänge des NAND-Gatters G1, des Flip-Flops F1 und des NOR-Gatters G5 angeschlossen sind, führt das erste Rückkopplungssignal. Das zweite Rückkopplungssignal liegt am Ausgang eines NAND-Gatters G7 an, dessen Eingänge an die Ausgänge des NAND-Gatters G2, des Flip-Flops F2 und des NOR-Gatters G5 angeschlossen sind. Erstes und zweites Rückkopplungssignal werden anschließend über einen Inverter G8 bzw. G9 geführt und bilden die Ausgangssignale UP bzw. DO des Phasendetektors PD.

Mittels des Rücksetzsignals RS ist es möglich, die Ausgangssignale UP und DO des Phasendetektors PD festzuhalten, d. h. den augenblicklichen Signalzustand an den Ausgängen des Phasendetektors PD beim Auftreten des Rücksetzsignals RS beizubehalten. Das Rücksetzsignal RS wird von einer Überwachungseinrichtung CC abgegeben, wenn das Eingangssignal IN und das Vergleichssignal CS gleich Null sind. Dies entspricht einer AND-Verknüpfung dieser beiden Signale. Um die Schaltgenauigkeit der Überwachungseinrichtung CC weiter zu erhöhen, reagiert die Überwachungseinrichtung CC erst beim Auftreten des Signals DO.

Das Ausführungsbeispiel zeigt eine bevorzugte Ausführungsform einer Überwachungseinrichtung CC. Dabei sind die Eingänge eines NOR-Gatters G11 mit dem Eingangssignal IN und dem Vergleichssignal CS beaufschlagt. Der Ausgang des NOR-Gatters G11 ist mit einem Eingang eines NAND-Gatters G12 verbunden, an dessen anderen Eingang das Ausgangssignal DO des Phasendetektors PD angelegt ist und an dessen Ausgang das Rücksetzsignal RS anliegt.

Bedingt durch Laufzeiten im Phasendetektor können beim Auftreten des Rücksetzsignals RS beim Ausgangssignal DO unerwünschte Spikes entstehen. Um dies zu unterbinden, wird das Ausgangssignal DO in Weiterbildung der Erfindung mit dem Eingangssignal IN getaktet. Dies erfolgt beispielsweise mittels eines AND-Gatters G10, an dessen einen Eingang das Ausgangssignal DO und an dessen anderen Eingang das Eingangssignal IN gelegt ist und dessen Ausgangssignal zur Ansteuerung der Ladungspumpe CP vorgesehen ist.

Die Ladungspumpe CP besteht aus zwei Stromquellen Q1 und Q2 die jeweils über einen Schalter S1 und S2 auf den Ausgang aufschaltbar sind, wobei der Schalter S1 durch das Ausgangssignal UP des Phasendetektors PD und der Schalter S2 durch das Ausgangssignal des AND-Gatters G10 gesteuert werden. Der Ladungspumpe CP ist ein beispielsweise aus einem Widerstand R und zwei Kondensatoren C1 und C2 aufgebautes Schleifenfilter LF nachgeschaltet. Die am Kondensator C2, dem der Widerstand R und der Kondensator C1 in Reihe parallelgeschaltet sind, anliegende Spannung stellt das Steuersignal FO für den spannungsgesteuerten Oszillator CO dar.

Vorteile der erfindungsgemäßen Schaltungsanordnung sind zum einen, da alle Maßnahmen zum sicheren Einrasten auf der richtigen Frequenz im Phasendetektor durchgeführt werden, der geringe Schaltungsaufwand und zum anderen eine hohe Eingangsjittertoleranz.

**Patentansprüche**

1. Schaltungsanordnung zur Nachlaufsynchronisation mit einem Phasendetektor (PD), an den ein Eingangssignal (IN) sowie ein Vergleichssignal (CS) angelegt sind und der Ausgangssignale (UP, DO) abgibt,
   mit einer Ladungspumpe (CP), die beim Auftreten entsprechender Ausgangssignale (UP, DO) des Phasendetektors (PD) einen Lade- oder Entladestrom (IP) abgibt,
   mit einem Schleifenfilter (LF), dem der Lade- oder Entladestrom (IP) zugeführt wird und das ein Steuersignal (FO) abgibt, und
   mit einem Oszillator (CO), der das Vergleichssignal (CS), dessen Frequenz von dem Steuersignal (FO) des Schleifenfilters (LF) abhängt, abgibt,
   **dadurch gekennzeichnet,**
   daß beim Phasendetektor (PD) die Ausgangssignale (UP, DO) durch Anlegen eines Rücksetzsignals (RS) festgehalten werden und daß eine Überwachungseinrichtung (CC) vorgesehen ist, die ein Rücksetzsignal (RS) abgibt, wenn Eingangssignal (IN) und Vergleichssignal (CS) gleich Null sind, wobei die Überwachungseinrichtung (CC) nur dann ein Rücksetzsignal (RS) abgibt, wenn zusätzlich das einen Entladestrom bei der Ladungspumpe (CP) bewirkende Ausgangssignal (DO) des Phasendetektors (PD) auftritt.

2. Schaltungsanordnung nach Anspruch 1,
   **dadurch gekennzeichnet,**
   daß mindestens eines der Ausgangssignale (DO) des Phasendetektors (PD) durch das Eingangssignal (IN) getaktet wird.

3. Schaltungsanordnung nach einem der Ansprüche 1 bis 2,
   **gekennzeichnet durch**
   einen Phasendetektor (PD)
   mit einem ersten NAND-Gatter (G1), an dessen Eingänge das Eingangssignal (IN), das Rücksetzsignal (RS) und ein erstes Rückkopplungssignal 1 angelegt sind, mit einem zweiten NAND-Gatter (G2), an dessen Eingänge das Vergleichssignal (CS), das Rücksetzsignal (RS) und ein zweites Rückkopplungssignal angelegt sind, mit einem ersten Flip-Flop (F1), dessen invertierender Setzeingang ($\overline{S}$) mit dem Ausgang des ersten NAND-Gatters (G1) verbunden ist, mit einem zweiten Flip-Flop (F2), dessen invertierender Setzeingang ($\overline{S}$) mit dem Ausgang des zweiten NAND-Gatters (G2) verbunden ist, mit einem ersten AND-Gatter (G4), dessen Eingänge an die Ausgänge vn erstem und zweitem NAND-Gatter (G1, G2) sowie von erstem und zweitem Flip-Flop (F1, F2) angeschlossen sind, mit einem ersten Inverter (G3), an dessen Eingang das Rücksetzsignal (RS) gelegt ist, mit einem ersten NOR-Gatter (G5), dessen Eingänge mit den Ausgängen von erstem Inverter (G3) sowie erstem AND-Gatter (G4) verbunden sind und dessen Ausgang mit den invertierenden Rücksetzeingängen ($\overline{R}$) von erstem und zweitem Flip-Flops (F1, F2) gekoppelt ist, mit einem dritten NAND-Gatter (G6), dessen Eingänge an die Ausgänge von erstem NAND-Gatter (G1), erstem Flip-Flop (F1) sowie erstem NOR-Gatter (G5) angeschlossen sind und dessen Ausgang das erste Rückkopplungssignal führt, mit einem vierten NAND-Gatter (G7), dessen Eingänge an die Ausgänge von zweitem NAND-Gatter (G2), zweitem Flip-Flop (F2) sowie erstem NOR-Gatter (G5) angeschlossen sind und dessen Ausgang das zweite Rückkopplungssignal führt, mit einem zweiten Inverter (G8), dessen Eingang mit dem Ausgang des dritten NAND-Gatters (G6) verbunden ist und dessen Ausgang das dem Ladestrom zugeordnete Ausgangssignal (UP) führt, und mit einem dritten Inverter (G9), dessen Eingang mit dem Ausgang des vierten NAND-Gatters (G7) verbunden ist und dessen Ausgang das dem Entladestrom zugeordnete Ausgangssignal (DO) führt.

4. Schaltungsanordnung nach einem der Ansprüche 1 bis 3,
   **gekennzeichnet durch**
   eine Überwachungseinrichtung J(CC),
   mit einem NOR-Gatter (G11), an dessen Eingänge das Eingangssignal (IN) und das Vergleichssignal (CS) angelegt sind, und
   mit einem NAND-Gatter (G12), an dessen einen Eingang der Ausgang des NOR-Gatters (G11) geführt ist sowie an dessen anderen Eingang das dem Entladestrom zugeordnete Ausgangssignal (DO) angelegt ist udn dessen Ausgang das Rücksetzsignal (RS) führt.

**Claims**

1. Circuit arrangement for tracking synchronization having a phase detector (PD), to which an input signal (IN) and a comparison signal (CS) are applied and which delivers output signals (UP, DO), having a charge pump (CP), which delivers a charging current or discharging current (IP) upon the occurrence of corresponding output signals (UP, DO) of the phase detector (PD), having a loop filter (LF), to which the charging current or discharging current (IP) is fed and which delivers a control signal (FO), and having an oscillator (CO), which delivers the comparison signal (CS), the frequency of which is dependent upon the control signal (FO) of the loop filter (LF), characterized in that in the case of the phase detector (PD) the output signals (UP, DO) are locked by application of a reset signal (RS), and in that a monitoring device (CC) is provided, which delivers a reset signal (RS) when input signal (IN) and comparison signal (CS) are equal to zero, the monitoring device (CC) delivering a reset signal (RS) only when in addition that output signal (DO) of the phase detector (PD) which causes a discharging current at the charge pump (CP) occurs.

2. Circuit arrangement according to Claim 1, characterized in that at least one of the output signals (DO) of the phase detector (PD) is clocked by the input signal (IN).

3. Circuit arrangement according to one of Claims 1 to 2, characterized by a phase detector (PD) having a first NAND gate (G1), to the inputs of which the input signal (IN), the reset signal (RS) and a first feedback signal 1 are applied, having a second NAND gate (G2), to the inputs of which the comparison signal (CS), the reset signal (RS) and a second feedback signal are applied, having a first flip-flop (F1), the inverting set input ($\overline{S}$) of which is connected to the output of the first NAND gate (G1), having a second flip-flop (F2), the inverting set input ($\overline{S}$) of which is connected to the output of the second NAND gate (G2), having a first AND gate (G4), the inputs of which are connected to the outputs of the first and second NAND gate (G1, G2) as well as of the first and second flip-flop (F1, F2), having a first invertor (G3), to the input of which the reset signal (RS) is applied, having a first NOR gate (G5), the inputs of which are connected to the outputs of the first invertor (G3) as well as the first AND gate (G4) and the output of which is coupled with the inverting reset inputs ($\overline{R}$) of the first and second flip-flop (F1, F2), having a third NAND gate (G6), the inputs of which are connected to the outputs of the first NAND gate (G1), the first flip-flop (F1) and the first NOR gate (G5) and the output of which carries the first feedback signal, having a fourth NAND gate (G7), the inputs of which are connected to the outputs of the second NAND gate (G2), the second flip-flop (F2) as well as the first NOR gate (G5) and the output of which carries the second feedback signal, having a second invertor (G8), the input of which is connected to the output of the third NAND gate (G6) and the output of which carries the output signal (UP) associated with the charging current, and having a third invertor (G9), the input of which is connected to the output of the fourth NAND gate (G7) and the output of which carries the output signal (DO) associated with the discharging current.

4. Circuit arrangement according to one of Claims 1 to 3, characterized by a monitoring device J(CC), having a NOR gate (G11), to the inputs of which the input signal (IN) and the comparison signal (CS) are applied, and having a NAND gate (G12), to one input of which the output of the NOR gate (G11) is passed and to the other input of which the output signal (DO) associated with the discharging current is applied and the output of which carries the reset signal (RS).

**Revendications**

1. Montage de synchronisation par poursuite, comportant un détecteur (PD) de phase, auquel est appliqué un signal (IN) d'entrée ainsi qu'un signal (CS) de comparaison, et qui fournit des signaux (UP, DO) de sortie,

une pompe (CP) de charge, qui, lorsqu'apparaissent des signaux (UP, DO) de sortie correspondants du détecteur (PD) de phase, fournit un courant (IP) de charge ou de décharge,

un filtre (LF) de boucle, auquel est envoyé le courant (IP) de charge ou de décharge, et qui fournit un signal (FO) de commande, et

un oscillateur (CO) qui fournit le signal (CS) de comparaison, dont la fréquence dépend du signal (FO) de commande du filtre (LF) de boucle, caractérisé en ce que

pour le détecteur (PD) de phase, les signaux (UP, DO) de sortie sont maintenus par application d'un signal (RS) de réinitialisation et il est prévu un dispositif (CC) de contrôle, qui fournit un signal (RS) de réinitialisation, lorsque le signal d'entrée (IN) et le signal (CS) de comparaison sont égaux à zéro, le dispositif (CC) de contrôle ne fournissant un signal (RS) de réinitialisation, que lorsqu'en plus, le signal (DO) de sortie, provoquant un courant de décharge dans la pompe (CP) de charge, du détecteur (PD) de phase, apparaît.

2. Montage suivant la revendication 1, caractérisé en ce qu'au moins l'un des signaux (DO) de sortie du détecteur (PD) de phase est cadencé par le signal (IN) d'entrée.

3. Montage suivant l'une des revendications 1 et 2, caractérisé par

un détecteur (PD) de phase comportant

une première porte (G1) NON-ET, dont les entrées reçoivent le signal (IN) d'entrée, le signal (RS) de réinitialisation et un premier signal (IN) de rétroaction,

une seconde porte (G2) NON-ET, dont les entrées reçoivent le signal (CS) de comparaison, le signal (RS) de réinitialisation et un second signal de rétroaction, une première bascule bistable (F1), dont l'entrée $(\overline{S})$ inverseuse de positionnement est reliée à la sortie de la première porte (G1) NON-ET,

une seconde bascule bistable (F2), dont l'entrée $(\overline{S})$ inverseuse de positionnement est reliée à la sortie de la seconde porte (G2) NON-ET,

une première porte (G4) ET, dont les entrées sont connectées aux sorties des première et seconde portes (G1, G2) NON-ET, ainsi qu'à celles des première et seconde bascules bistables (F1, F2),

un premier inverseur (G3), à l'entrée duquel est appliqué le signal (RS) de réinitialisation,

une première porte (G5) NI, dont les entrées sont reliées à la sortie du premier inverseur (G3) ainsi qu'à celle de la première porte (G4) ET et dont la sortie est couplée aux entrées $(\overline{R})$ inverseuses de réinitialisation des première et seconde bascules bistables (F1, F2),

une troisième porte (G6) NON-ET, dont les entrées sont connectées aux sorties de la première porte (G1) NON-ET, de la première bascule bistable (F1) ainsi que de la première porte (G5) NI, et dont la sortie fournit le premier signal de rétroaction,

une quatrième porte (G7) NON-ET, dont les entrées sont connectées aux sorties de la seconde porte (G2) NON-ET, de la seconde bascule bistable (F2), ainsi que de la première porte (G5) NI et dont la sortie fournit le second signal de rétroaction,

un second inverseur (G8), dont l'entrée est reliée à la sortie de la troisième porte (G6) NON-ET, et dont la sortie fournit le signal (UP) de sortie associé au courant de charge, et

un troisième inverseur (G9), dont l'entrée est reliée à la sortie de la quatrième porte (G7) NON-ET et dont la sortie fournit le signal (DO) de sortie associé au courant de décharge.

4. Montage suivant l'une des revendications 1 à 3, caractérisé par

un dispositif J(CC) de contrôle, comportant

une porte (G11) NI, dont les entrées reçoivent le signal (IN) d'entrée et le signal (CS) de comparaison, et
une porte (G12) NON-ET, dont une des entrées reçoit la sortie de la porte (G11) NI, dont l'autre entrée reçoit le signal (DO) de sortie associé au courant de décharge et dont la sortie fournit le signal (RS) de réinitialisation.